# EUROPEAN PATENT APPLICATION

(11) **EP 3 769 939 A1**
(43) Date of publication of application: **27.01.2021**
(21) Application number: 19203102.9
(22) Date of filing: 14.10.2019
(51) Int. Cl.: B29C 64/393, B33Y 50/02, H04N 1/56

(54) **SLICING METHOD FOR HORIZONTAL FACETS OF COLOR 3D OBJECT**

(30) Priority: 23.07.2019 CN 201910666421
(71) Applicant: XYZprinting, Inc., New Taipei City 22201 (TW); Kinpo Electronics, Inc., New Taipei City 22201 (TW)
(72) Inventor: SHIH, Ko-Wei, 22201 New Taipei City (TW); HSIEH, Hsin-Ta, 22201 New Taipei City (TW); HUANG, Yu-Ting, 22201 New Taipei City (TW); HO, Kwan, 22201 New Taipei City (TW)
(74) Representative: 2K Patentanwälte Blasberg Kewitz & Reichel

(57) **Abstract**

A slicing method for horizontal facets of color 3D object includes following steps: executing a slicing procedure; calculating an intersection (4) of any polygon facet (3) of a color 3D object with one of a plurality of slicing planes (2); determining whether the polygon facet (3) is a horizontal facet; determining whether the slicing plane (2) currently processed is a highest slicing plane intersecting with the polygon facet (3) if the polygon facet (3) is determined as a horizontal facet; calculating another intersection(4) of the polygon facet (3) with next slicing plane (2) if the slicing plane (2) currently processed is not the highest slicing plane; performing a pixelated procedure to the polygon facet (3) for generating pixelated color data (5) if the slicing plane (2) currently processed is the highest slicing plane; and storing the pixelated color data (5) to a slicing file of the highest slicing plane.

## Description

### BACKGROUND OF THE INVENTION

### 1.Technical Field

The technical field relates to a color 3D object, and specifically relates to a slicing method for horizontal facets of the color 3D object.

### 2.Description of Related Art

Before a printing procedure is performed by a 3D printer, a user has to first execute a slicing procedure to a 3D object to be printed through a computer, the slicing procedure is executed to slice the 3D object by multiple slicing planes for generating a plurality of printing layers (also called cross-sectional layers) upon horizontal direction, and record the information of these printing layers into slicing files. Once the 3D printer imports the slicing files, it may print these printing layers layer-by-layer according to the content of the slicing files, and fabricates a physical 3D model by stacking these printing layers.

Generally speaking, a color 3D object described by a computer aided design (CAD) software is constituted by multiple color polygon facets, such as multiple triangular facets. When performing the aforementioned slicing procedure, a printing layer may simultaneously intersect with multiple polygon facets of the color 3D object. When performing a printing procedure, the 3D printer is basically coloring the polygon facets at each of the intersections for forming the outlook color of a color 3D model.

Basically, the intersection of each slicing plane and each polygon facet is just one line. For making the color brighter and more visible, the 3D printer may enhance and print such line as a color band with certain width. However, if a polygon facet of a color 3D object is considered as a horizontal facet and intersects with multiple slicing planes, multiple color bands printed at different printing layers may be visually influenced with each other and the overall resolution will be reduced. As a result, the outlook color of the color 3D model associated with such polygon facet will be distorted and damage the quality of the color 3D model.

### SUMMARY OF THE INVENTION

The disclosure is directed to a slicing method for horizontal facets of color 3D object, which applies different approach to calculate the color information of each slicing plane intersected with a polygon facet of the color 3D object which is considered as a horizontal facet, so as to save the color of a printed 3D model from distortion.

In one of the exemplary embodiments, the slicing method for horizontal facets of color 3D object is mainly implemented by a 3D object processing apparatus and includes following steps of:
performing a slicing procedure by the 3D object processing apparatus; calculating an intersection of one slicing plane and any polygon facet of a 3D object; determining whether the polygon facet is a horizontal facet; determining whether the slicing plane currently processed is a highest slicing plane intersecting with the polygon facet when determining that the polygon facet is a horizontal facet; calculating an intersection of next slicing plane and the polygon facet if the slicing plane currently processed is not the highest slicing plane; performing a pixelated procedure to the polygon facet for generating pixelated color data if the slicing plane is currently processed in the highest slicing plane; and writing the pixelated color data into a slicing file of the highest slicing plane.

In comparison with related art, when a polygon facet of a 3D object is considered to be a horizontal facet, the present invention directly writes the color information of the entire polygon facet to a slicing file of a highest slicing plane of multiple slicing planes that are intersected with the polygon facet, so as to prevent a fabricated physical 3D model from color distortion due to the color with reduced resolution.

### DESCRIPTION OF THE DRAWINGS

FIG. 1 is a schematic diagram of a slicing plane of a first embodiment according to the present invention.
FIG. 2A is a schematic diagram depicting a tilted angle of a polygon facet of a first embodiment according to the present invention.
FIG. 2B is a schematic diagram depicting the tilted angle of the polygon facet of a second embodiment according to the present invention.
FIG. 3 is a flowchart for slicing and printing of a first embodiment according to the present invention.
FIG. 4 is a schematic diagram depicting a set associated with a polygon facet of a first embodiment according to the present invention.
FIG. 5 is a schematic diagram for printing the polygon facet of a first embodiment according to the present invention.
FIG. 6 is a block diagram of a color 3D printer of a first embodiment according to the present invention.
FIG. 7 is a schematic diagram for printing a polygon facet of a second embodiment according to the present invention.
FIG. 8 is a schematic diagram for printing a polygon facet of a third embodiment according to the present invention.
FIG. 9 is a schematic diagram indicating outlooks of different 3D objects fabricated by different approaches.

### DETAILED DESCRIPTION OF THE INVENTION

In cooperation with the attached drawings, the technical contents and detailed description of the present invention are described hereinafter according to multiple embodiments, being not used to limit its executing scope. Any equivalent variation and modification made according to appended claims is all covered by the claims claimed by the present invention.

The present invention discloses a slicing method for horizontal facets of color 3D object (referred to as the slicing method hereinafter), the slicing method is implemented by 3D object processing apparatuses, such as personal computers, servers, 3D printers, etc. for performing a slicing procedure to a 3D object. The 3D object in the following description is a digital content drawn, built, and created by a user through computer aided design (CAD) software for describing a physical 3D model in digital way. The 3D object processing apparatuses may perform the slicing procedure to the 3D object for generating slicing information associated with multiple printing layers of the 3D object, and the 3D printers may print the physical 3D model corresponding to the 3D object according to the slicing information.

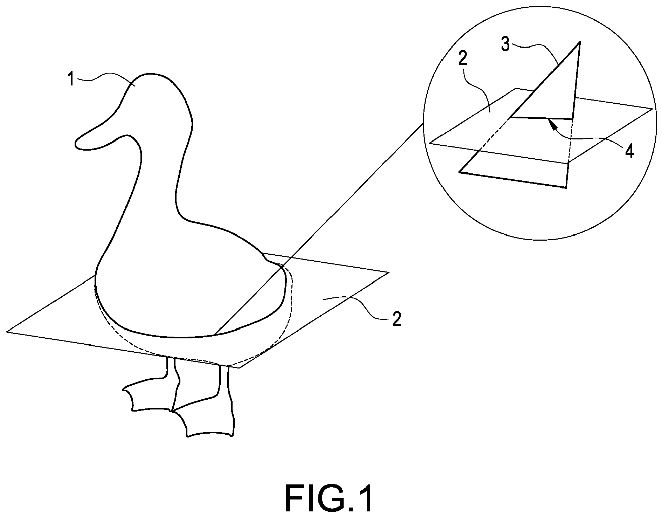

FIG. 1 is a schematic diagram of a slicing plane of a first embodiment according to the present invention. FIG. 1 discloses a 3D object 1. In this embodiment, the 3D object 1 is a color 3D object and is constituted by multiple color polygon facets 3. In the disclosure of FIG. 1, each of the polygon facets 3 is illustrated as a triangular facet, but not limited thereto.

When performing a slicing procedure, the aforementioned 3D object processing apparatus slices the 3D object 1 horizontally according to multiple slicing planes 2 in an X-Y direction (i.e., a direction parallel to X axis and Y axis) for generating a plurality of printing layers stacked in a Z direction (i.e., a direction parallel to Z axis), wherein the Z direction is perpendicular to the X-Y direction, and each of the plurality of printing layers is respectively corresponding to one of the slicing planes 2. As disclosed in FIG. 1, each of the slicing planes 2 may respectively has an intersection 4 with one or more polygon facets 3 of the 3D object 1, and the intersection 4 is a position that the 3D printer has to color through jetting color inks in following printing procedure. In this embodiment, the 3D printer in the printing procedure is to color the position of the intersections 4 where the slicing planes 2 intersect with the polygon facets 3, and the color applied by the 3D printer is exactly the same as the color assigned to each of the polygon facets 3.

As discussed above, if one of the polygon facets 3 of the 3D object 1 has been considered as a horizontal facet (i.e., the tilted angle of this polygon facet 3 with respect to an X-Y surface is approaching to 0 degree), and the 3D object processing apparatus neglects to process this polygon facet 3 in the slicing procedure, as a result, a physical 3D model fabricated by the 3D printer may have seriously distortion in outlook color due to the reduced resolution.

One of a plurality of technical features of the present invention is that, when performing the slicing procedure, the 3D object processing apparatus may additionally determine whether the angle of each polygon facet 3 of the 3D object with respect to the X-Y plane exceeds a threshold or not. If the angle of any one of the polygon facets 3 exceeds the threshold (i.e., bigger than certain degrees), the 3D object processing apparatus may consider that this polygon facet 3 is not a horizontal facet, so the 3D object processing apparatus slices this polygon facet 3 according to standard slicing process for generating a record of corresponding slicing information. On the contrary, if the angle of any one of the polygon facets 3 does not exceed the threshold, the 3D object processing apparatus may consider the polygon facet 3 as a horizontal facet (i.e., the angle of the polygon facet 3 with respect to the X-Y plane is horizontal or near horizontal), so the 3D object processing apparatus slices this polygon facet 3 according to the slicing method provided by the present invention for generating a record of corresponding slicing information (detailed described in the following).

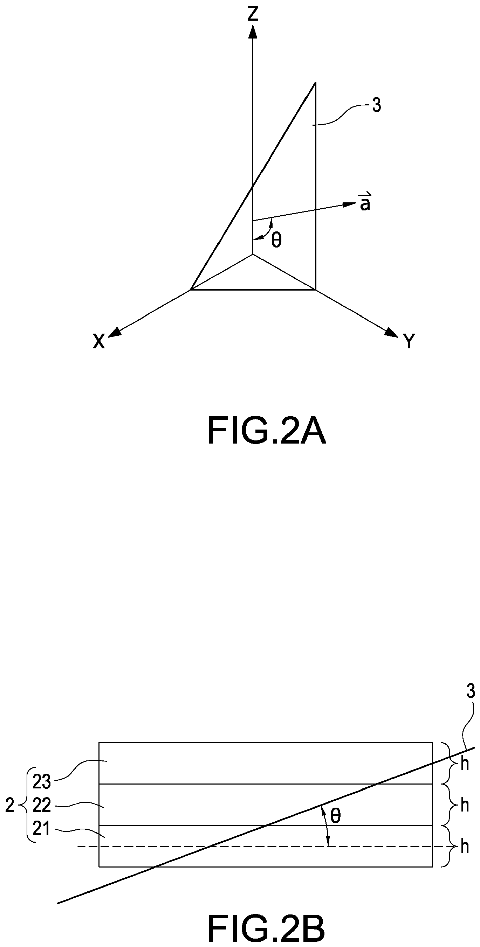

Refers to FIG. 2A and FIG. 2B, wherein FIG. 2A is a schematic diagram depicting a tilted angle of a polygon facet of a first embodiment according to the present invention, FIG. 2B is a schematic diagram depicting the tilted angle of the polygon facet of a second embodiment according to the present invention.

As disclosed in FIG. 2A, the 3D object 1 positioned in a three-dimensional coordinates system is constituted by an X axis, a Y axis, and a Z axis, and each vertex of each polygon facet 3 (illustrated as a triangular facet in FIG. 2A) is respectively has specific coordinates in such coordinates system. In this embodiment, after a polygon facet 3 is drawn, built, and created completely, the information associated with this polygon facet 3 may include the coordinates of each vertex of this polygon facet 3, and the 3D object processing apparatus may obtain such information during the slicing procedure, and constitute this polygon facet 3 according to the coordinates of the vertex, and further determines a normal vector direction of the polygon facet 3.

In this embodiment, the 3D object processing apparatus mainly calculates an angle θ between the normal vector direction of each polygon facet 3 and an X-Y plane (i.e., the direction parallel to the slicing plane 2) during the slicing procedure, and determines whether each polygon facet 3 can be considered as a horizontal facet according to the calculated angle θ. The aforementioned angle θ is between 0 degree and 90 degrees. Once the angle θ is getting smaller, the polygon facet 3 is considered closer to horizontal. On the contrary, once the angle θ is getting bigger, the polygon facet 3 is considered closer to vertical.

In one embodiment, such threshold can be set as 10 degrees. During the slicing procedure, the 3D object processing apparatus will determine that a polygon facet 3 is a horizontal facet once an angle θ between the normal vector of the polygon facet 3 and the X-Y plane is equal to or smaller than 10 degrees. Accordingly, the 3D object processing apparatus may perform slicing process to this polygon facet 3 according to the slicing method provided by the disclosure.

As disclosed in FIG. 2B, if an area of one polygon facet 3 is big, it may be across multiple slicing planes 2 at different heights along the Z axis, and simultaneously intersects with these slicing planes. In the embodiment disclosed in FIG. 2B, the polygon facet 3 has intersections respectively with at least a first slicing plane 21, a second sling plane 22, and a third slicing plane 23.

As discussed above, if the polygon facet 3 has intersections respectively with the first slicing plane 21, the second slicing plane 22, and the third slicing plane 23, the 3D printer needs to jet color ink that corresponds to the color of the polygon facet 3 at these intersections (i.e., creating said color band), so as to form the color of a physical 3D model. However, if the angle θ between the polygon facet 3 and the X-Y plane is too small (i.e., the polygon facet 3 is considered as a horizontal plane), the inks jetted at adjacent slicing planes may affect each other and reduce the overall resolution of the entire 3D model, and eventually cause a distortion in the outlook color of the 3D model.

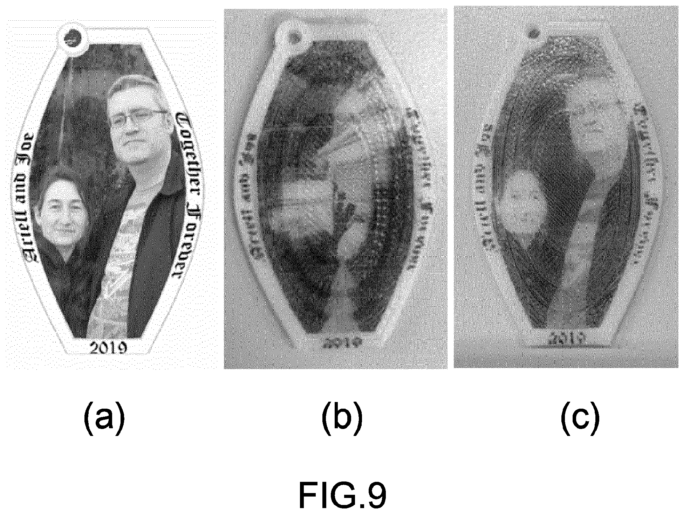

FIG. 9 is a schematic diagram indicating outlooks of different 3D objects fabricated by different approaches. Part (a) of FIG. 9 discloses an outlook of a normal 3D object. Part (b) of FIG. 9 indicates a physical 3D model printed based on data processed by a standard slicing process even if the one or more polygon facets of the 3D object is/are horizontal facets. As shown in part (b) of FIG. 9, the fabricated 3D model is hardly affected by the distortion of the outlook color.

It should be mentioned that in the embodiment of FIG. 2B, each slicing plane 2 respectively has a thickness h, and the thickness h is corresponding to the layer thickness of each printing layer used by the 3D printer. In this case, such thickness h may affect the resolution of the fabricated 3D model as well.

The aforementioned thickness h is usually related to the ability of hardware mechanism of the 3D printer, so it has a limitation in adjustment. Besides, such angle θ of the polygon facets 3 is confirmed right after the 3D object 1 is completely drawn, built, and created, which means the 3D object processing apparatus cannot amend such angle θ during the slicing procedure. As a result, the present disclosure provides a novel slicing method to solve the outlook color distortion of the 3D model while the thickness h and the angle θ are hard to be amended.

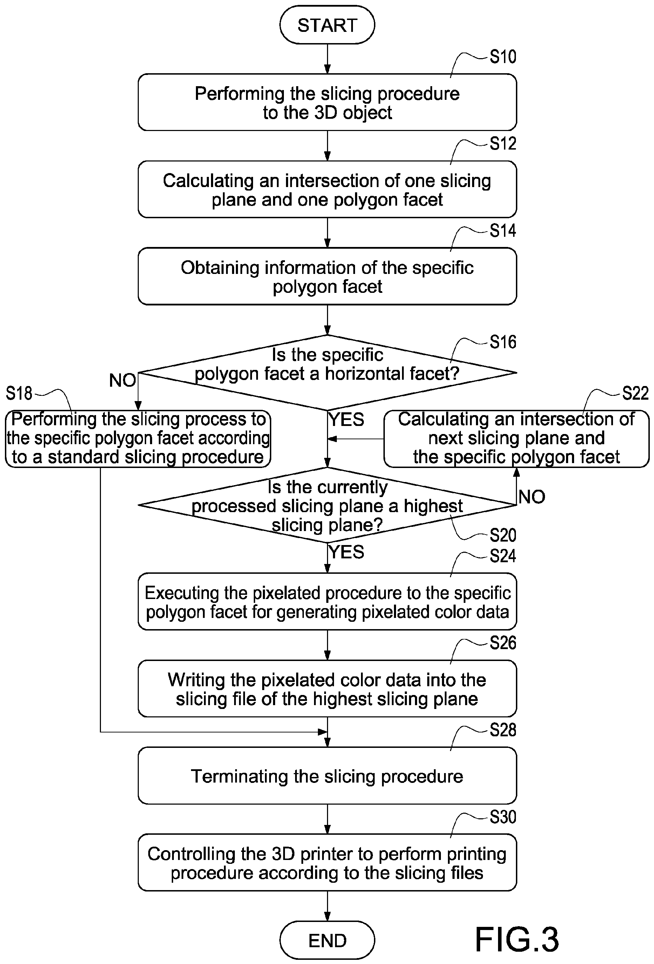

FIG. 3 is a flowchart for slicing and printing of a first embodiment according to the present invention. FIG. 3 discloses specific steps of the slicing method of the present invention, and the slicing method is mainly implemented by a 3D object processing apparatus which is capable of performing the slicing procedure, such as a personal computer, a tablet computer, a server, a 3D printer, etc., but not limited thereto.

As shown in FIG. 3, the 3D object processing apparatus imports a 3D object 1 that a user demands to print, and performs the slicing procedure to the 3D object 1 (step S10). The slicing procedure uses multiple slicing planes 2 having same thickness (i.e., have same height in a Z axis direction) to divide the imported 3D object 1 (i.e., cut the 3D object 1 along a direction parallel to an X-Y plane), so as to generate slicing data of multiple printing layers needed by the 3D printer for printing. Also, these slicing data are written to slicing files respectively corresponding to each of the slicing planes 2.

Next, the 3D object processing apparatus calculates an intersection of one of the multiple slicing planes (such as a lowest slicing plane) and one of multiple polygon facets 3 (referred to as a specific polygon facet hereinafter) of the 3D object 1 during the slicing procedure (step S12). As discussed above, the slicing procedure involves multiple slicing planes 2, and each slicing plane 2 may simultaneously intersect with multiple polygon facets 3 of the 3D object 1 (i.e., respectively has an intersection with each polygon facet 3). For the sake of interpretation, the following section will use a single one polygon facet 3 of the 3D object 1 as an example for detailed description, but not limited thereto.

When the 3D object processing apparatus discovers that such slicing plane 2 has an intersection with the specific polygon facet of the 3D object 1 in the step S12, it obtains information of the specific polygon facet (step S14). In one embodiment, such information may be, for example, the coordinates of each vertex of the specific polygon facet, and a set including one or more slicing planes 2 associated with the specific polygon facet, wherein such set records layer marks of the multiple slicing planes 2 which intersect with the specific polygon facet.

In particular, the thickness h of each slicing plane 2 is usually known, and the coordinates of each vertex of each polygon facet 3 are also known after the 3D object 1 is completely drawn, built, and created. A computer apparatus such as the computer apparatus used to draw, build, and create the 3D object 1 may calculate a height of the specific polygon facet along the Z axis according to the coordinates of each vertex of the specific polygon facet, and calculates which slicing plane(s) 2 the specific polygon facet has crossed through dividing the height by the thickness h of the slicing plane 2, and then records the layer mark(s) of the slicing plane(s) 2 into the set associated with the specific polygon facet.

For example, the polygon facet 3 shown in FIG. 2B has crossed the first slicing plane 21, the second slicing plane 22, and the third slicing plane 23, so a set associated with the polygon facet 3 must record at least the layer marks of the first slicing plane 21, the second slicing plane 22, and the third slicing plane 23.

By obtaining such information of the specific polygon facet (including at least the set and the coordinates of the vertex), the 3D object processing apparatus may determine how to perform the slicing process to the specific polygon facet (detailed described in the following).

After the step S14, the 3D object processing apparatus determines whether the specific polygon facet is a horizontal facet matching with a determination standard (step S16). In particular, the 3D object processing apparatus in the step S16 is to calculate the angle θ between the specific polygon facet and an X-Y plane according to the information of the specific polygon facet, and determine whether the specific polygon facet is a horizontal facet which matches with the determination standard according to the angle θ.

More specific, the 3D object processing apparatus in the step S16 is to obtain the coordinates of each vertex of the specific polygon facet from the information, and calculate a normal vector direction of the specific polygon facet according to the coordinates of these vertex. The aforementioned angle θ indicates the angle between the normal vector of the specific polygon facet and another normal vector of the X-Y plane.

In one embodiment, the 3D object processing apparatus may set 10 degrees as a threshold of the aforementioned determination standard, i.e., once the angle θ is bigger than 10 degrees (in other words, bigger than the threshold), the 3D object processing apparatus may determine that the specific polygon facet is not matching with the determination standard, which cannot be considered as a horizontal facet. On the contrary, if the angle θ is equal to or smaller than 10 degrees, the 3D object processing apparatus may consider the specific polygon facet as a horizontal facet which matches with the determination standard.

However, the above descriptions are only part of the exemplary embodiments, the present invention is not limited thereto.

If the 3D object processing apparatus determines that the specific polygon facet is not a horizontal facet in the step S16, i.e., the angle θ of the specific polygon facet with respect to the X-Y plane is bigger than the threshold, the 3D object processing apparatus may then perform the slicing process to the specific polygon facet according to a standard slicing procedure (step S18).

In particular, in the standard slicing procedure, the 3D object processing apparatus is to obtain the color of the positions of the specific polygon facet where intersect with each of the slicing planes 2, automatically generates color bands which respectively have a specific width and related color along each intersection, and writes the data of each color band into the slicing file of each slicing plane 2.

If the 3D object processing apparatus determines that the specific polygon face is a horizontal facet in the step S16 (i.e., the angle θ of the specific polygon facet is equal to or smaller than the threshold), the 3D object processing apparatus may then perform the slicing process to the specific polygon facet according to the slicing method provided by the present invention.

In this disclosure, the 3D object processing apparatus executes a pixelated procedure (also known as a rasterized procedure) to the entire polygon facet 3 which is considered as a horizontal facet for generating pixelated color data of the polygon facet 3. If the polygon facet 3 only has an intersection with one slicing plane 2, the 3D object processing apparatus will directly write the pixelated color data into a slicing file of this slicing plane 2. If the polygon facet 3 simultaneously intersects with multiple slicing planes 2, i.e., has multiple intersections respectively with multiple slicing planes 2, the 3D object processing apparatus will write the pixelated color data into a slicing file of a highest slicing plane of the multiple slicing planes 2 which respectively intersect with the polygon facet 3 (detailed described in the following).

In one embodiment, the slicing file may be, for example, a G-Code file, but not limited thereto.

In particular, if the 3D object processing apparatus determines that the specific polygon facet is a horizontal facet in the step S16, it may further determine whether the specific polygon facet simultaneously intersects with multiple slicing planes 2 according to the information of the specific polygon facet. If the specific polygon facet intersects with only one slicing plane 2 (i.e., only has an intersection with one slicing plane 2), the 3D object processing apparatus directly executes the pixelated procedure to the specific polygon facet for generating the pixelated color data, and then write the pixelated color data into the slicing file of this slicing plane 2 which intersects with the specific polygon facet.

If the 3D object processing apparatus determines that the specific polygon facet simultaneously intersects with multiple slicing planes 2 according to the information of the specific polygon facet, it further determines whether the currently processed slicing plane 2 is the highest slicing plane of the multiple slicing planes 2 that intersect with the specific polygon facet (step S20). In particular, the 3D object processing apparatus is to determine whether to calculate color information of the specific polygon facet or not in the step S20.

If the 3D object processing apparatus determines that the currently processed slicing plane 2 is not the highest slicing plane which has an intersection with the specific polygon facet in the step S20, it further calculates an intersection of next slicing plane 2 and the specific polygon facet (step S22), and the slicing method goes back to the step S20, so the 3D object processing apparatus may then determine whether the next slicing plane 2 (i.e., the next processed slicing plane 2) is the aforementioned highest slicing plane of the multiple slicing planes 2 intersecting with the specific polygon facet.

In the present disclosure, the 3D object processing apparatus processes each of the multiple slicing planes 2 along a Z axis direction from bottom to top, once one of the multiple slicing planes 2 is determined having an intersection with the specific polygon facet (e.g., a lowest slicing plane of the multiple slicing planes 2), every slicing plane 2 between the lowest slicing plane and the aforementioned highest slicing plane must intersects with the specific polygon facet (i.e., must respectively has an intersection with the specific polygon facet).

It should be mentioned that, in a first embodiment, the 3D object processing apparatus in the step S22 may calculate the color information at the intersection of the next slicing plane 2 and the specific polygon facet, write the color information into the slicing file of the next slicing plane 2, and then delete the color information in following slicing procedure. In a second embodiment, the 3D object processing apparatus in the step S22 may calculate the color information at the intersection of the next slicing plane 2 and the specific polygon facet, write the color information into the slicing file of the next slicing plane 2, but the 3D printer will neglect coloring this slicing plane 2 in following printing procedure. In a third embodiment, the 3D object processing apparatus only calculates an intersection of the next slicing plane 2 and the specific polygon facet but not calculates the color information at this intersection, so as to reduce the calculation time.

If the 3D object processing apparatus determines that the currently processed slicing plane 2 is the aforementioned highest slicing plane in the step S20, it may then execute the pixelated procedure (also known as a rasterized procedure) to the specific polygon facet for generating corresponding pixelated color data (step S24). Also, the 3D object processing apparatus directly write the generated pixelated color data into the slicing file of the highest slicing plane (step S26). In this embodiment, the slicing file may be a G-Code file, but not limited thereto.

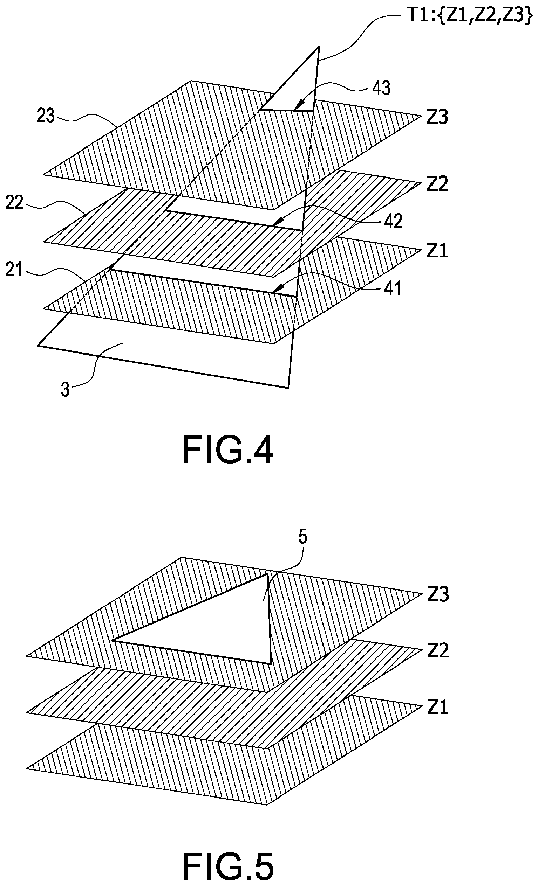

Please refer to FIG. 4 and FIG. 5, wherein FIG. 4 is a schematic diagram depicting a set associated with a polygon facet of a first embodiment according to the present invention, FIG. 5 is a schematic diagram for printing the polygon facet of a first embodiment according to the present invention.

In the embodiment of FIG. 4, a polygon facet 3 simultaneously intersects with three slicing planes is taken as an example. In particular, the polygon facet 3 in FIG. 4 has a first intersection 41 with a first slicing plane 21 (corresponding to a first layer Z1), a second intersection 42 with a second slicing plane 22 (corresponding to a second layer Z2), and a third intersection 43 with a third slicing plane 23 (corresponding to a third layer Z3).

In this embodiment, the information of the polygon facet 3 has recorded a set T 1 right after the polygon facet 3 is drawn, built, and created, and the set T1 records layer marks of all of the slicing planes 2 intersecting with the polygon facet 3. In the embodiment of FIG. 4, the layer marks may be, for example, said Z1, Z2, and Z3 for respectively indicating the first layer, the second layer, and the third layer, but not limited thereto.

As shown in FIG. 5, when calculating the first intersection 41 of the polygon facet 3 and the first slicing plane 21, the 3D object processing apparatus may discover that the first slicing plane 21 is not a highest slicing plane which intersects with the polygon facet 3 according to the content of the set T1. In this case, the 3D object processing apparatus does not calculate the color information of the first intersection 41. When calculating the second intersection 42 of the polygon facet 3 and the second slicing plane 22, the 3D object processing apparatus may discover that the second slicing plane 22 is not the highest slicing plane that intersects with the polygon facet 3 according to the content of the set T1. In this case, the 3D object processing apparatus still neglect calculating the color information of the second intersection 42.

When calculating the third intersection 43 of the polygon facet 3 and the third slicing plane 23, the 3D object processing apparatus may discover that the third slicing plane 23 is the highest slicing plane which intersects with the polygon facet 3 according to the content of the set T1. In this case, the 3D object processing apparatus executes a pixelated procedure to the polygon facet 3 for generating pixelated color data 5 that corresponds to the entire polygon facet 3, and directly writes the pixelated color data 5 into a slicing file of the third slicing plane 23 (i.e., the highest slicing plane). In particular, the pixelated procedure is to transform the polygon facet 3 in a three-dimensional space into pixel data in a two-dimensional space (i.e., an X-Y plane), so the 3D printer may be allowed to use the pixel data during its printing procedure.

As discussed above, the 3D object processing apparatus won't calculate the color information of the intersection related to the slicing plane(s) 3 other than the highest slicing plane, and it will record the color information of the entire polygon facet 3 into the slicing file of the highest slicing plane. In this embodiment, the angle between the polygon facet 3 and the X-Y plane is small and the polygon facet 3 is considered as a horizontal facet, even if the color information of the entire polygon facet 3 is directly printed on the highest slicing plane, a user may still see a fabricated 3D model precisely without distortion in outlook color.

Part (c) of FIG. 9 indicates a physical 3D model printed based on data processed by the slicing method of the present invention. As disclosed in part (c) of FIG. 9, by way of the special slicing method provided by the present invention, the fabricated 3D model may have the outlook color more precise than that as shown in part (b) of FIG. 9.

Please refer back to FIG. 3. After the step S26, the 3D object processing apparatus may terminate the slicing procedure (step S28). After slicing procedure is terminated, the user may further control the 3D printer to perform its printing procedure according to the slicing files (step S30), so as to fabricate the physical 3D model.

In one embodiment, the 3D object processing apparatus and the 3D printer may be two separated apparatuses, the user may use the 3D object processing apparatus to perform the slicing procedure to a 3D object 1 for generating the slicing file of each printing layer, and then imports the slicing files into the 3D printer for the 3D printer to perform the printing procedure for fabricating a corresponding physical 3D mode. In another embodiment, the 3D object processing apparatus and the 3D printer may be integrated into one single apparatus (such as a special 3D printer), and the user may use the 3D printer to perform both the slicing procedure and the printing procedure.

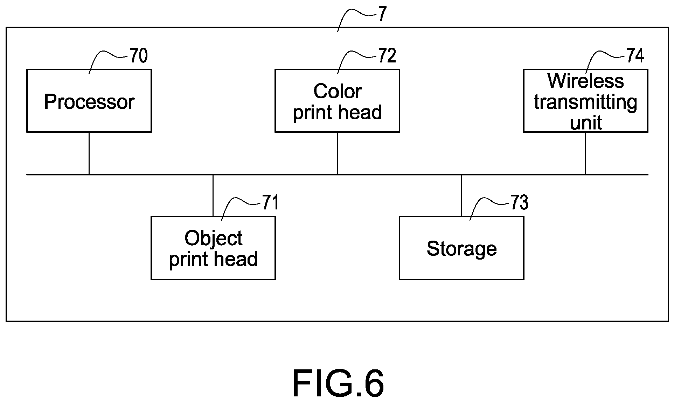

FIG. 6 is a block diagram of a color 3D printer of a first embodiment according to the present invention. FIG. 6 discloses a 3D printer 7 which has been embedded with function of the aforementioned 3D object processing apparatus. As disclosed in FIG. 6, the 3D printer 7 at least includes a processor 70, and an object print head 71, a color print head 72, a storage 73, and a wireless transmitting unit 74 which are electrically connected with the processor 70 through serial buses. In this embodiment, the 3D printer 7 is taken for an example for performing both the slicing procedure and the printing procedure. In another embodiment, however, the slicing procedure and the printing procedure may also be performed separately and respectively by the aforementioned 3D object processing apparatus and the 3D printer, not limited thereto.

In this embodiment, the 3D printer 7 may perform the slicing method provided by the present invention through the processor 70 for generating the aforementioned slicing files. Besides, in the step S30 shown in FIG. 3, the processor 70 may control the object print head 71 to extrude material and control the color print head 72 to jet color ink according to the slicing files, so as to fabricate a physical 3D model. The above object print head 71 for extruding material and the color print head 72 for jetting color ink are common technique in 3D printing field, detailed description is therefore omitted.

The storage 73 is used for storing the slicing files generated by the slicing procedure performed by the processor 70. In one embodiment, the 3D printer 7 performs the slicing procedure to a 3D object through the processor 70 for generating the corresponding slicing files, and then stores the slicing files into the storage 73. In another embodiment, the 3D printer 7 may receive externally the slicing files generated by other apparatus through the wireless transmitting unit 74, and controls the object print head 71 and the color print head 72 directly according to the received slicing files, but not limited thereto.

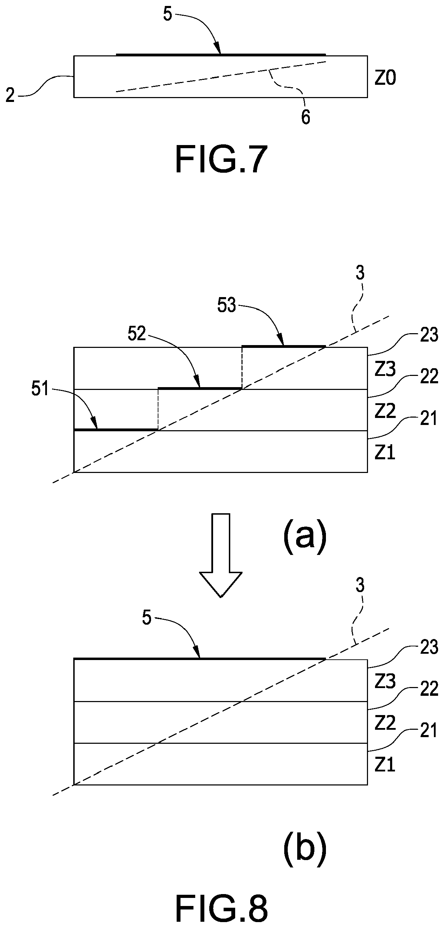

FIG. 7 is a schematic diagram for printing a polygon facet of a second embodiment according to the present invention. If a polygon facet 6 is a horizontal facet (i.e., the angle between the polygon facet 6 and an X-Y plane is smaller than a threshold), and the size of the polygon facet 6 is small enough that the polygon facet 6 only has an intersection with one slicing plane 2 (for example, the slicing plane 2 having a layer mark Z0), the 3D printer 7 may directly execute the pixelated procedure to the polygon facet 6 during the slicing procedure for generating the pixelated color data 5, and directly write the pixelated color data 5 into the slicing file of this slicing plane 2.

When performing the printing procedure, the 3D printer 7 may control the object print head 71 to extrude material according to the content of the slicing file for printing a corresponding object. Also, the 3D printer 7 may control the color print head 72 to jet color ink according to the content of the slicing file for coloring each printed object. Therefore, each of the colored objects may respectively has an outlook color same as the polygon facet 6.

FIG. 8 is a schematic diagram for printing a polygon facet of a third embodiment according to the present invention. FIG. 8 discloses a polygon facet 3 which is considered as a horizontal facet, wherein the polygon facet 3 has a bigger size and simultaneously intersects with multiple slicing planes 2. In the embodiment of FIG. 8, the polygon facet 3 simultaneously intersects with the first slicing plane 21 (having a layer mark Z1), the second slicing plane 22 (having a layer mark Z2), and the third slicing plane 23 (having a layer mark Z3).

When performing the slicing procedure, the 3D printer 7 determines that the polygon facet 3 is a horizontal plane, and then it performs the slicing process to the polygon facet 3 according to the slicing method provided by the present invention as discussed above.

If performing the slicing process to the polygon facet 3 according to a standard slicing procedure, what is shown in part (a) of FIG. 8 will happen. In this case, the 3D printer 7 generates first color data 51 for an intersection of the polygon facet 3 and the first slicing plane 21 and writes the first color data 51 into a slicing file of the first slicing plane 21, generates second color data 52 for an intersection of the polygon facet 3 and the second slicing plane 22 and writes the second color data 52 into a slicing file of the second slicing plane 22, and generates third color data 53 for an intersection of the polygon facet 3 and the third slicing plane 23 and writes the third color data 53 into a slicing file of the third slicing plane 23.

When performing the printing procedure, the 3D printer 7 controls the object print head 71 to print three layers of object respectively corresponding to the first slicing plane 21, the second slicing plane 22, and the third slicing plane 23, and controls the color print head 72 to jet color ink according to the slicing files of all of the first slicing plane 21, the second slicing plane 22, and the third slicing plane 23, so as to respectively color the three layers of object respectively corresponding to the first slicing plane 21, the second slicing plane 22, and the third slicing plane 23. After being colored, the three layers of object may have the same outlook color as the polygon facet 3.

If performing the slicing process to the polygon facet 3 according to the slicing method provided by the present invention, what is shown in part (b) of FIG. 8 will happen. In this case, the 3D printer 7 won't calculate the color information for an intersection of the polygon facet 3 and the first slicing plane 21, nor the color information for an intersection of the polygon facet 3 and the second slicing plane 22, but directly calculates the pixelated color data 5 of the entire polygon facet 3 and directly writes the pixelated color data 5 into a slicing file of a highest slicing plane intersecting with the polygon facet 3 (which is the third slicing plane 23 in FIG. 8).

When performing the printing procedure, the 3D printer 7 controls the object print head 71 to print three layers of object respectively corresponding to the first slicing plane 21, the second slicing plane 22, and the third slicing plane 23, and controls the color print head 72 to jet color ink according to the slicing file of the third slicing plane 23 (i.e., the highest slicing plane) for coloring the object corresponding to the highest slicing plane. Therefore, the object corresponding to the highest slicing plane may have the same outlook color as the entire polygon facet 3 after being colored.

By using the technical solution provided by the present invention, if one polygon facet is considered as a horizontal facet, the 3D printer may print the outlook color of the entire polygon facet directly on a highest slicing plane intersecting with this polygon facet, so as to prevent a physical 3D model from distortion in outlook color due to the low color resolution, so as to improve the quality of printing of the 3D model.

## Claims

1. A slicing method for horizontal facets of color 3D object implemented by a 3D object processing apparatus, comprising following steps of:
a) performing a slicing procedure to a 3D object (1) by the 3D object processing apparatus, wherein the 3D object (1) is constituted by multiple color polygon facets;
b) calculating an intersection (4) of a specific polygon facet (3) of the multiple color polygon facets and one slicing plane (2) during the slicing procedure by the 3D object processing apparatus, wherein the slicing plane (2) is parallel to an X-Y plane;
c) determining whether the specific polygon facet (3) is a horizontal facet according to information of the specific polygon facet (3);
d) performing a pixelated procedure to the specific polygon facet (3) by the 3D object processing apparatus for generating pixelated color data (5) when determining that the specific polygon facet (3) is a horizontal facet; and
e) writing the pixelated color data (5) into a slicing file of the slicing plane (2).

2. The slicing method in claim 1, wherein the step e) is writing the pixelated color data (5) into the slicing file of a highest slicing plane of a plurality of the slicing planes (2) respectively having an intersection (4) with the specific polygon facet (3).

3. The slicing method in claim 1, wherein the step d) comprises following steps:
d11) determining whether the specific polygon facet (3) intersects with multiple slicing planes (2) according to the information of the specific polygon facet (3) when determining that the specific polygon facet (3) is a horizontal facet; and
d12) performing the pixelated procedure to the specific polygon facet (3) for generating the pixelated color data (5) when determining that the specific polygon facet (3) intersects with only one slicing plane (2), and then executes the step e).

4. The slicing method in claim 1, wherein the step d) comprises following steps:
d21) determining whether the slicing plane (2) currently processed is a highest slicing plane of a plurality of the slicing planes (2) intersecting with the specific polygon facet (3) according to the information of the specific polygon facet (3) when determining that the specific polygon facet (3) is a horizontal facet;
d22) calculating an intersection (4) of a next slicing plane (2) of the plurality of slicing planes (2) and the specific polygon facet (3) if the slicing plane (2) currently processed is not the highest slicing plane, and again executing the step d21); and
d23) performing the pixelated procedure to the specific polygon facet (3) for generating the pixelated color data (5) if the slicing plane (2) currently processed is the highest slicing plane, and next executing the step e), wherein the step e) is writing the pixelated color data (5) into the slicing file of the highest slicing plane.

5. The slicing method in claim 4, wherein the information of the specific polygon facet (3) comprises a set (T1), the set (T1) records layer marks of the plurality of slicing planes (2) intersecting with the specific polygon facet (3), and the step d21) determines whether the slicing plane (2) currently processed is the highest slicing plane of the plurality of slicing planes (2) intersecting with the specific polygon facet (3) according to the layer marks.

6. The slicing method in claim 4, wherein the 3D object processing apparatus neglects calculating color information for an intersection (4) of the next slicing plane (2) and the specific polygon facet (3) in the step d22).

7. The slicing method in claim 1, wherein the information of the specific polygon facet (3) comprises coordinates of each vertex of the specific polygon facet (3) on a three-dimensional coordinates system, the step c) obtaining a normal vector direction of the specific polygon facet (3) according to the coordinates, calculating an angle (θ) between the normal vector of the specific polygon facet (3) and another normal vector of an X-Y plane, and determining whether the specific polygon facet (3) is a horizontal facet based on the angle (θ).

8. The slicing method in claim 7, wherein the step c) determines that the specific polygon facet (3) is a horizontal facet if the angle (θ) is equal to or smaller than 10 degrees.

9. The slicing method in claim 1, wherein the multiple color polygon facets are triangular facets, the slicing file is a G-Code file.

10. The slicing method in claim 1, further comprising following steps of:
f) terminating the slicing procedure by the 3D object processing apparatus after the step e); and
g) controlling an object print head (71) and a color print head (72) respectively to perform a printing procedure according to the slicing file by a 3D printer (7).
